# EUROPEAN PATENT APPLICATION

(11) **EP 2 315 262 A2**
(43) Date of publication of application: **27.04.2011**
(21) Application number: 09806823.2
(22) Date of filing: 10.08.2009
(51) Int. Cl.: H01L 31/042

(54) **SOLAR CELL AND METHOD FOR MANUFACTURING SAME**

(30) Priority: 11.08.2008 KR 20080078659; 26.08.2008 KR 20080083461; 27.08.2008 KR 20080084158
(71) Applicant: TG Solar Corporation, Gyeonggi-do 445-812 (KR)
(72) Inventor: LEE, Yoo Jin, Yongin-si Gyeonggi-do 448-550 (KR); JANG, In Goo, Goyang-si Gyeonggi-do 410-742 (KR); KIM, Dong Jee, Seongnam-si Gyeonggi-do 463-909 (KR); JANG, Seok Pil, Suwon-si Gyeonggi-do 441-729 (KR); LEE, Young Ho, Yongin-si Gyeonggi-do 448-519 (KR); LEE, Byung Il, Seongnam-si Gyeonggi-do 463-804 (KR); JANG, Taek Yong, Suwon-si Gyeonggi-do 443-470 (KR)
(74) Representative: Samson & Partner
(86) International application number: PCT/KR2009/004451
(87) International publication number: WO 2010/018961

(57) **Abstract**

A solar cell and a manufacturing method thereof are disclosed. The solar cell in accordance with the present invention includes a substrate 100; a lower electrode 111a formed on the substrate 100; a photoelectric element unit 200a including a polycrystalline photoelectric element 210 formed on the lower electrode 111a and formed by stacking a plurality of polycrystalline semiconductor layers 211a, 212a, and 213a, and a amorphous photoelectric element 220 formed on the polycrystalline photoelectric element 210 and formed by stacking a plurality of amorphous semiconductor layers 221, 222, and 223; and an upper electrode 400 formed on the photoelectric element unit 200a.

## Description

### Technical Field

The present invention relates to a solar cell and a method for fabricating the same, and more particularly, to a tandem type solar cell in which a photoelectric element including a polycrystalline semiconductor layer and an amorphous semiconductor layer are stacked, and a method for fabricating the same. Further, the present invention relates to a solar cell, in which a plurality of tandem type solar cells as unit cells are connected in series, having an improved photoelectric conversion efficiency and reliability and incurring a low fabrication cost, and a method for fabricating the same.

### Background Art

In general, a conventional thin film type solar cell has approximately 10 percent or less of photoelectric conversion efficiency, and thus has many difficulties to be put to practical use.

Therefore, in order to overcome such problem, a tandem type solar cell configured by stacking a plurality of single junction type photoelectric elements, and a series connection type solar cell configured by connecting a plurality of single junction type photoelectric elements in series have been proposed.

First, the tandem type solar cell employs a structure in which a plurality of photoelectric elements are stacked, each of which has a different band gap of a light absorption layer, which absorbs light of various wavelength bands to produce a larger amount of electricity.

For example, Saitoh et al. fabricated a p-i-n type amorphous silicon (a-Si)/microcrystalline Si (µc-Si) tandem type silicon solar cell by using a plasma enhanced chemical vapor deposition (PECVD), in which an initial photoelectric conversion efficiency was 9.4% and a stabilized photoelectric conversion efficiency was 8.5% per 1cm².

However, the tandem type silicon solar cell developed by Saitoh et al. requires low deposition pressure and high deposition power conditions in forming microcrystalline silicon using the PECVD. Thus, it has a problem in that PECVD process time is too long and PECVD process conditions are hardly met or adjusted, thus having a low productivity.

Meanwhile, the series connection type solar cell employs a structure in which a plurality of photoelectric elements, each having the same band gap of a light absorption layer, are connected in series, increasing the area of the light absorption layer to produce a larger amount of electricity.

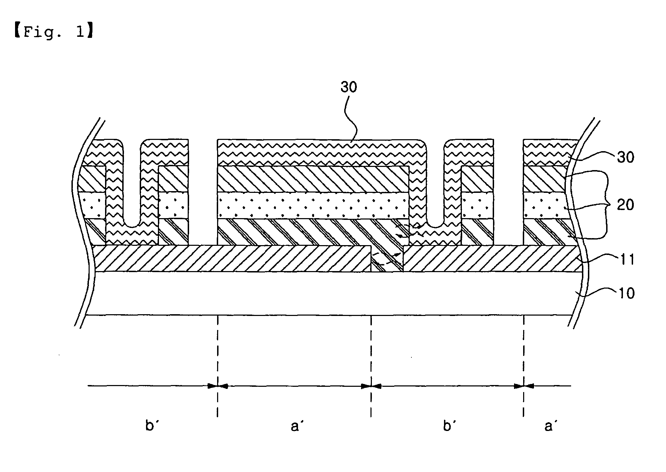

Fig. 1 is a view illustrating the structure of a conventional series connection type solar cell.

First, as shown therein, in the conventional series connection type solar cell, a substrate 10 including a plurality of wiring areas b' positioned between a plurality of unit cell areas a' is provided. Next, a lower electrode layer 11 is formed at the unit cell area a' on the substrate 10, a photoelectric element unit 20 with semiconductor layers stacked thereon is formed on the lower electrode layer 11, and an upper electrode 30 is formed on the photoelectric element unit 20, thus constituting a single unit cell of a solar cell. At this point, the upper electrode 30 is connected with the lower electrode layer 11 of a neighboring unit cell of the solar cell at the wiring area b', whereby the plurality of photoelectric element units 20 are electrically connected in series.

However, in the conventional series connection type solar cell, when the unit cells of the solar cell are connected at the wiring area b', the side of the photoelectric element unit 20 and the upper electrode 30 are short-circuited to generate an unnecessary leakage current. In addition, in conventional series connection type solar cell, because n type or p type semiconductor layer which is doped with impurities and thus has a low resistance, among the semiconductor layers constituting the photoelectric element unit 20, is formed between the lower electrode layers 11 of the neighboring unit cells of the solar cell, a short-circuit phenomenon may occur between the unit cells of the solar cell, thus degrading the photoelectric conversion efficiency of the solar cell.

### Disclosure

### Technical Problem

It is, therefore, an object of the present invention to provide a solar cell having a structure in which polycrystalline photoelectric elements and amorphous photoelectric elements are stacked, each of the stacked photoelectric elements receiving light of a different wavelength, to thereby improve a photoelectric conversion efficiency, and a method for manufacturing the same.

Another object of the present invention is to provide a solar cell capable of preventing a short-circuit phenomenon potentially occurring between a photoelectric element and an upper electrode in a wiring area when unit cells of the solar cell are connected in series, and a method for manufacturing the same.

Still another object of the present invention is to provide a solar cell capable of preventing a short-circuit phenomenon potentially occurring between lower electrode layers of unit cells of the solar cell in a wiring area when the unit cells of the solar cell are connected in series, and a method for manufacturing the same.

Still another object of the present invention is to provide a solar cell capable of reducing a manufacturing process and shortening a process time when the unit cells of the solar cell are connected in series, to thereby save a manufacturing cost, and a method for manufacturing the same.

### Technical Solution

In accordance with one aspect of the present invention, there is provided a solar cell comprising: a substrate; a lower electrode formed on the substrate; a photoelectric element unit including a polycrystalline photoelectric element formed on the lower electrode and formed by stacking a plurality of polycrystalline semiconductor layers and a amorphous photoelectric element formed on the polycrystalline photoelectric element and formed by stacking a plurality of amorphous semiconductor layers; and an upper electrode formed on the photoelectric element unit.

In accordance with another aspect of the present invention, there is provided a method for fabricating a solar cell, comprising: forming a lower electrode on a substrate; forming a photoelectric element unit on the lower electrode, wherein the photoelectric element unit includes a polycrystalline photoelectric element formed by stacking a plurality of polycrystalline semiconductor layers formed on the lower electrode and an amorphous photoelectric element formed by stacking a plurality of amorphous semiconductor layers formed on the polycrystalline photoelectric element; and forming an upper electrode on the photoelectric element unit.

### Advantageous Effects

In accordance with the present invention, a structure, in which polycrystalline photoelectric elements and amorphous photoelectric elements are stacked, is employed to allow each of the stacked photoelectric elements to receive light of a different wavelength, thereby improving a photoelectric conversion efficiency of a solar cell.

In addition, in accordance with the present invention, it is possible to prevent a short-circuit phenomenon potentially occurring between a photoelectric element and an upper electrode in a wiring area when unit cells of the solar cell are connected in series.

Moreover, in accordance with the present invention, it is possible to prevent a short-circuit phenomenon potentially occurring between lower electrode layers of unit cells of the solar cell in a wiring area when the unit cells of the solar cell are connected in series.

Further, in accordance with the present invention, it is possible to save a manufacturing cost by reducing a manufacturing process and shortening a process time when the unit cells of the solar cell are connected in series.

### Description of Drawings

The above and other objects and features of the present invention will become apparent from the following description of the preferred embodiments given in conjunction with the accompanying drawings, in which:
Fig. 1 is a view illustrating the structure of a conventional series connection type solar cell;
Figs. 2 to 5 are views illustrating a tandem type solar cell and a manufacturing method thereof in accordance with an embodiment of the present invention;
Figs. 6 to 11 are views illustrating a series connection type solar cell and a manufacturing method thereof in accordance with a first embodiment of the present invention;
Figs 12 to 17 are views illustrating a series connection type solar cell and a manufacturing method thereof in accordance with a second embodiment of the present invention;
Figs. 18 to 22 are views illustrating a series connection type solar cell and a manufacturing method thereof in accordance with a third embodiment of the present invention;
Figs. 23 to 27 are views illustrating a series connection type solar cell and a manufacturing method thereof in accordance with a fourth embodiment of the present invention; and
Figs. 28 and 29 are views illustrating a method for manufacturing a side wall insulating layer and an electrode connection layer of a solar cell in accordance with an embodiment of the present invention.

### Best Mode for the Invention

Hereinafter, preferred embodiments of the present invention will be described in detail with reference to the accompanying drawings so that those skilled in the art to which the present invention pertains can easily practice the invention.

### Structure of tandem type solar cell

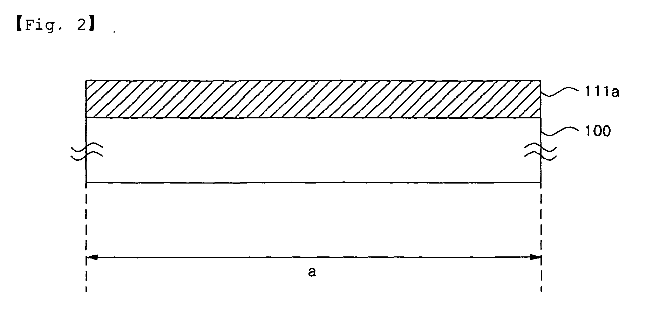

Figs. 2 to 5 are views illustrating a tandem type solar cell and a manufacturing method thereof in accordance with an embodiment of the present invention.

A substrate 100 includes a plurality of unit cell areas (a) and a plurality of wiring areas (b) positioned between a plurality of unit cell areas (a), and hereinafter, the unit cell area (a) will be mainly described, for convenience.

First, referring to Fig. 2, the substrate 100 is prepared. The substrate 100 may be made of a transparent material or an opaque material. The substrate 100 may be made of glass, plastic, silicon, metal, stainless steel (SUS), or the like.

In this case, a surface of the substrate 100 may be textured. Here, a texturing refers to roughing a surface of a substrate, namely, forming protrusion and depression patterns on the surface of the substrate in order to prevent degradation of a photoelectric conversion efficiency of a solar cell by an optical loss caused by a reflection of light incident onto the surface of the substrate of the solar cell. When the surface is textured to be rough, the light once reflected from the surface of the substrate is reflected again to reduce reflectance of light, thus increasing a capturing amount of light to improve the photoelectric conversion efficiency of the solar cell.

Also, an anti-reflection layer (not shown) may be formed on the substrate 100. The anti-reflection layer may serve to prevent the occurrence of a phenomenon in which solar light incident through the substrate 100, failing to be absorbed into an light absorbing layer of the solar cell, is directly reflected to outside to degrade the photoelectric conversion efficiency of the solar cell. The anti-reflection layer may be made of silicon oxide (SiOₓ) or silicon nitride (SiNₓ), but is not necessarily limited thereto. A method for forming the anti-reflection layer may include a low pressure chemical vapor deposition (LPCVD), a plasma enhanced chemical vapor deposition (PECVD), and the like.

Subsequently, a lower electrode 111a made of a conductive material is formed on the substrate 100. The lower electrode 111a may be made of a material which has a low contact resistance and electrical characteristics not degraded although a high temperature process is performed. Namely, the material of the lower electrode 111a may be one of molybdenum (Mo), tungsten (W), molybdenum tungsten (MoW), or an alloy thereof, but is not necessarily limited thereto. Namely, the material of the lower electrode 111a may include general conducive materials, such as copper, aluminum, titanium, and the like, or alloy thereof. A method for forming the lower electrode 111a may include a physical vapor deposition (PVD) such as a thermal evaporation, an E-beam evaporation, or a sputtering, and a chemical vapor deposition (CVD) such as LPCVD, PECVD, a metal organic chemical vapor deposition (MOCVD).

Meanwhile, a reflection layer (not shown) made of a transparent conductive material may be additionally formed on the lower electrode 111a. Namely, the reflection layer is positioned between the lower electrode 111a and a polycrystalline photoelectric element 210 to be formed later. The reflection layer, which is electrically connected to the lower electrode 111a, reflects solar light incident from an upper side of the substrate 100 to improve the photoelectric conversion efficiency of the solar cell. The reflection layer may be made of AZO (ZnO:Al) obtained by adding a small amount of Al to ZnO, but is not is necessarily limited thereto. Namely, the material of the reflection layer may include general transparent conducive materials, such as ITO (Indium Tin Oxide), ZnO (Zinc Oxide), IZO (Indium Zinc Oxide), FSO (SnO:F) obtained by adding a small amount of F to SnO. A method for forming the reflection layer may include PVD such as a sputtering, or the like, and CVD such as LPCVD, PECVD, MOCVD, or the like.

Also, the surface of the lower electrode 111a may be textured in order to improve the photoelectric conversion efficiency of the solar cell, like the surface of the substrate 100 as discussed above.

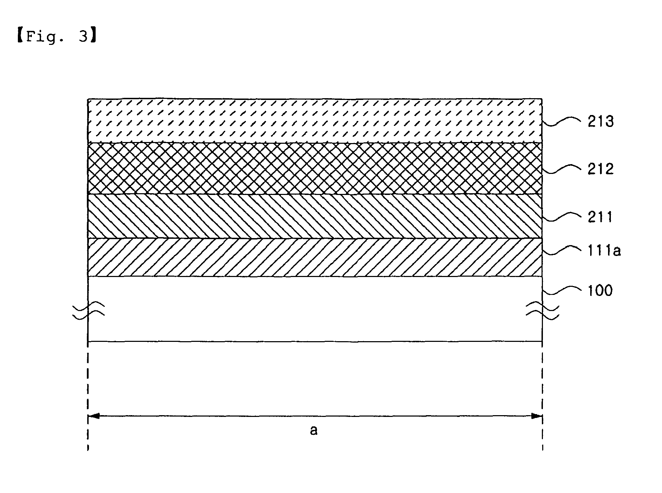

Next, referring to Fig. 3, p type and n type semiconductor layers may be stacked on the lower electrode 111a, or a p type, i type, and n type semiconductor layers may be stacked on the lower electrode 111a on the lower electrode 111a. In the present embodiment, for example, p type, i type, and n type semiconductor layers may be sequentially formed, and in this case, the p type, i type, and n type semiconductor layers may be made of silicon, which is a generally used semiconductor material. Namely, three amorphous silicon layers 211 to 213 may be formed.

More specifically, a first lower amorphous silicon layer 211 may be formed on the lower electrode 111a, a second lower amorphous silicon layer 212 may be formed on the first lower amorphous silicon layer 211, and then a third lower amorphous silicon layer 213 may be formed on the second lower amorphous silicon layer 212 to constitute a single photoelectric element. At this point, the first to third lower amorphous silicon layers 211 to 213 may be formed using CVD such as PECVD or LPCVD.

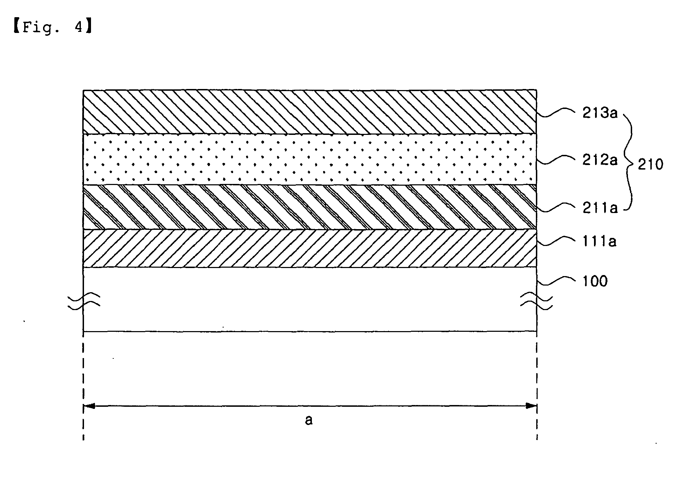

Next, referring to Fig. 4, the first to third lower amorphous silicon layers 211 to 213 may be crystallized. Namely, the first lower amorphous silicon layer 211 may be crystallized as a first polycrystalline silicon layer 211a, the second lower amorphous silicon layer 212 may be crystallized as a second polycrystalline silicon layer 212a, and the third lower amorphous silicon layer 213 may be crystallized as a third polycrystalline silicon layer 213a.

As a result, a polycrystalline photoelectric element 210 including the first to third polycrystalline silicon layers 211a to 213a may be formed on the lower electrode 111a. The polycrystalline photoelectric element 210 may have a structure in which the polycrystalline silicon layers are stacked, namely, a structure of a p-i-n diode in which p, i, and n type polycrystalline silicon layers are sequentially stacked, which can produce power with photoelectron-motive force generated as light is received. Here, i type polycrystalline silicon layer refers to an intrinsic silicon layer without impurities doped thereon.

Meanwhile, in the n type or p type doping, impurities may be preferably doped using an in situ method in forming the amorphous silicon layer. In general, boron (B) is used as an impurity in the p type doping and phosphor (P) or arsenic (As) is used as an impurity in the n type doping, but the present invention is not limited thereto and a known technique may be used without any limitations.

As a method for crystallizing the amorphous silicon, any one of solid phase crystallization (SPC), excimer laser annealing (ELA), sequential lateral solidification (SLS), metal induced crystallization (MIC), and metal induced lateral crystallization (MILC) may be used. The amorphous silicon crystallization method is well-known in the art, so a detailed description thereof will be omitted.

Meanwhile, in the above description, the first, second, and third lower amorphous silicon layers 211, 212, and 213 are all formed and then simultaneously crystallized, but the present invention is not necessarily limited thereto. For example, a crystallization process may be separately performed for each of the lower amorphous silicon layers, or two lower amorphous silicon layers may be simultaneously crystallized while the other remaining lower amorphous silicon layer may be separately crystallized.

In addition, a defect removing process may be additionally performed on the first to third polycrystalline silicon layers 211a, 212a, and 213a in order to further improve the general characteristics of the polycrystalline silicon layers. In the present invention, the polycrystalline silicon layers may be thermally treated at a high temperature or hydrogen plasma treated to remove defects (e.g., impurities, dangling bonds, etc.) present in the polycrystalline silicon layers.

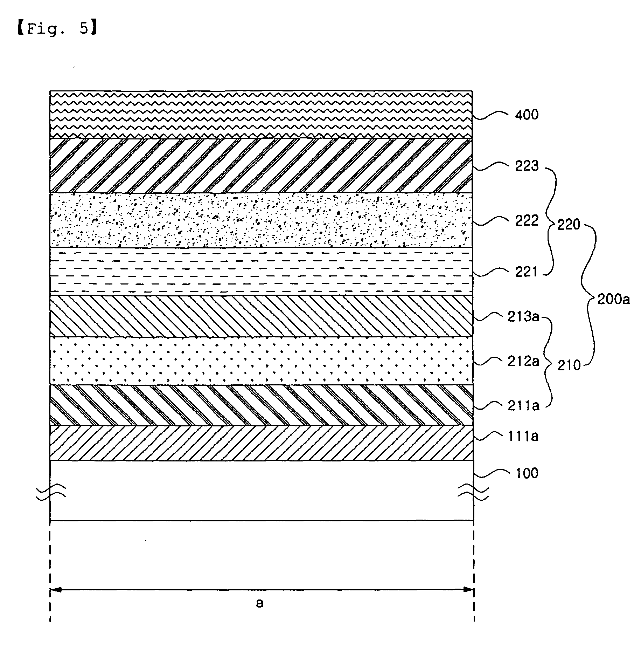

Finally, referring to Fig. 5, three amorphous silicon layers 221, 222, and 223 may be additionally formed on the polycrystalline photoelectric element 210. More specifically, the first upper amorphous silicon layer 221 may be formed on the third polycrystalline silicon layer 213a, the second upper amorphous silicon layer 222 may be formed on the first upper amorphous silicon layer 221, and then the third upper amorphous silicon layer 223 may be formed on the second upper amorphous silicon layer 222, to constitute the amorphous photoelectric element 220 having a p-i-n diode structure. In this case, the first to third amorphous silicon layers 221, 222, and 223 may be formed by using CVD such as PECVD or LPCVD.

Next, an upper electrode 400 made of a transparent conductive material may be formed on the third upper amorphous silicon layer 223. The upper electrode 400 may be preferably made of any one of ITO, ZnO, IZO, AZO (ZnO:Al), FSO (SnO:F), but the present invention is not limited thereto. A method for forming the upper electrode 400 may include PVD such as a sputtering, or the like, and CVD such as LPCVD, PECVD, MOCVD, or the like.

Accordingly, a photoelectric element unit 200a, including the polycrystalline photoelectric element 210 consisting of the polycrystalline silicon layers and the amorphous photoelectric element 220 consisting of the amorphous silicon layers employed for the tandem type solar cell in accordance with the embodiment of the present invention, may be obtained.

Meanwhile, although not shown, a connection layer made of a transparent conductive material may be additionally formed between the third polycrystalline silicon layer 213a and the first amorphous silicon layer 221. This connection layer forms a tunnel junction between the third polycrystalline silicon layer 213a and the first upper amorphous silicon layer 221 to obtain better photoelectric conversion efficiency of the solar cell. The connection layer may be preferably made of any one of ITO, ZnO, IZO, AZO (ZnO:Al), FSO (SnO:F), but the present invention is not limed thereto. A method for forming the connection layer may include PVD such as a sputtering, or the like, and CVD such as LPCVD, PECVD, MOCVD, or the like.

Because the polycrystalline photoelectric element 210 as described above includes the polycrystalline silicon layers, it has good photoelectric conversion efficiency over light of a long wavelength band, and because the amorphous photoelectric element 220 includes the amorphous silicon layers, it has good photoelectric conversion efficiency over light of a short wavelength band. Thus, the tandem type solar cell in accordance with the present embodiment can absorb light of various wavelength bands, thereby improving the photoelectric conversion efficiency of the solar cell.

In addition, because the tandem type solar cell in accordance with the present embodiment employs the high quality polycrystalline silicon, it has excellent aging characteristics (namely, aging is slow) compared with the conventional tandem type solar cell employing microcrystalline silicon. Namely, in terms of the characteristics of silicon, the amorphous silicon does not have good aging characteristics and, unlike the microcrystalline silicon, the polycrystalline silicon has little amorphous silicon, so the characteristics of the tandem type solar cell in accordance with the present invention are not easily degraded.

### Conductivity type of tandem type solar cell

In the tandem type solar cell in accordance with an embodiment of the present invention, the photoelectric element unit 220a including the polycrystalline and amorphous photoelectric elements 210 and 220 may preferably have four types of conductivity arrangements as follows. Hereinbelow, + and - indicate a relative difference of a doping density, and + has a higher doping density than -. For example, n+ is doped with higher density than n-. Also, if there is no indication of + or -, it means that there is no particular limitation in the doping density.

First, the first to third polycrystalline silicon layers 211a to 213a may have n, i, and p conductivity types, respectively, and the first to third upper amorphous silicon layers 221 to 223 may have n, i, and p conductivity types, respectively. In this case, preferably, the first to third polycrystalline silicon layers 221a to 213a have n+, i, and p+ conductivity types, respectively.

Second, the first to third polycrystalline silicon layers 211a to 213a may have n, n, and p conductivity types, respectively, and the first to third upper amorphous silicon layers 221 to 223 may have n, i, and p conductivity types, respectively. In this case, preferably, the first to third polycrystalline silicon layers 221a to 213a have n+, n-, and p+ conductivity types, respectively.

Third, the first to third polycrystalline silicon layers 211a to 213a may have p, i, and n conductivity types, respectively, and the first to third upper amorphous silicon layers 221 to 223 may have p, i, and n conductivity types, respectively. In this case, preferably, the first to third polycrystalline silicon layers 221a to 213a have p+, i, and n+ conductivity types, respectively.

Fourth, the first to third polycrystalline silicon layers 211a to 213a may have p, p, and n conductivity types, respectively, and the first to third upper amorphous silicon layers 221 to 223 may have p, i, and n conductivity types, respectively. In this case, preferably, the first to third polycrystalline silicon layers 221a to 213a have p+, p-, and n+ conductivity types, respectively.

In the above detailed description, the tandem type solar cell, in which the solar cell includes the polycrystalline and amorphous photoelectric elements 210 and 220 are dual-stacked as the photoelectric element unit, has been explained by way of example, but if necessary, the polycrystalline and amorphous photoelectric elements 210 and 220 may be triple-stacked or more.

### Series connection type solar cell

Hereinafter, the configuration of a series connection type solar cell including a plurality of unit cells of the tandem type solar cell in accordance with an embodiment of the present invention as described above, and a manufacturing method thereof will now be described.

### [First embodiment]

The configuration of a unit cell area (a) of the series connection type solar cell in accordance with a first embodiment of the present invention is the same as that of the unit cell area (a) of the tandem type solar cell as described above. Thus, a detailed description of the elements included in the unit cell area (a) will be omitted in the first embodiment hereinbelow in order to avoid repeated description.

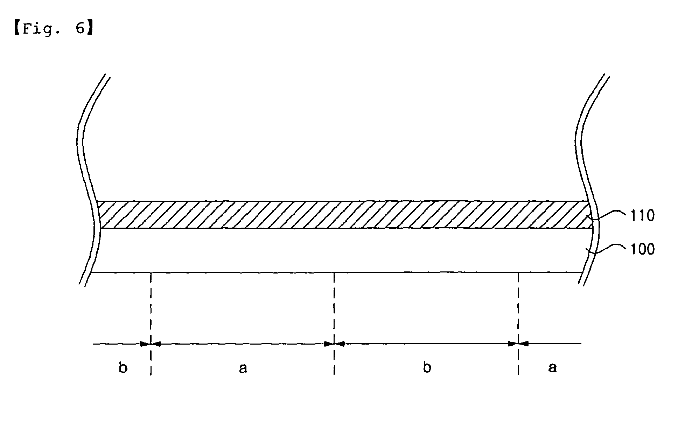

Figs. 6 to 11 are views illustrating a series connection type solar cell and a manufacturing method thereof in accordance with a first embodiment of the present invention.

First, referring to Fig. 6, a substrate 100 including a plurality of wiring areas (b) positioned between a plurality of unit cell areas (a) is provided.

In this case, an anti-reflection layer (not shown) may be additionally formed on the substrate 100 in order to prevent the occurrence of a phenomenon in which incident solar light, failing to be absorbed into an light absorbing layer of the solar cell, is directly reflected to outside to degrade the photoelectric conversion efficiency of the solar cell.

Next, a lower conductive layer 110 made of a conductive material is formed on the substrate 100. The lower conductive layer 110 may be formed by using the same material and method as those of the lower electrode 111a of the foregoing tandem type solar cell.

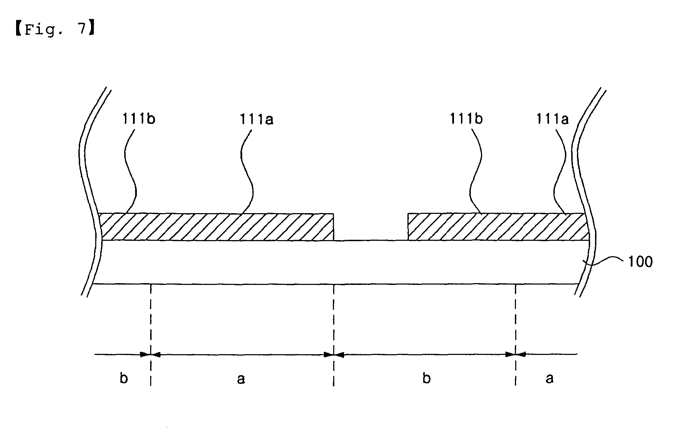

Subsequently, referring to Fig. 7, the lower conductive layer 110 may be patterned to form lower electrode layers 111 (111a and 111b) of certain patterns. For example, a laser scribing, which is an etching method using a laser light source, may be used. Hereinafter, in order to equivalently explain with the operational circuit of the solar cell, the lower electrode layer 111 formed at the unit cell area (a) will be described as a lower electrode 111a, and the lower electrode layer 111 formed at the wiring area (b) will be described as a lower connection electrode 111b. Namely, the lower electrode 111a serves as an electrode of a photoelectric element unit to be formed later, and the lower connection electrode 111b serves as a connection portion for connecting the photoelectric element unit to a neighboring different photoelectric element unit. Thus, the lower electrode 111a is formed on the unit cell area (a) of the substrate 100, and at the same time, the lower connection electrode 111b of certain patterns is formed at the wiring area (b) of the substrate 100 such that it is connected as the same layer to one side of the lower electrode 111a.

A reflection layer (not shown), which is a transparent conductive layer, may be additionally formed on the lower electrode 111a. Namely, the reflection layer may be positioned between the lower electrode 111a and the photoelectric element unit to be formed later. The reflection layer may be electrically connected with the lower electrode 111a and reflects incident solar light from an upper side of the substrate 100 to improve the photoelectric conversion efficiency of the solar cell. The reflection layer may be formed by using the same material and method as those of the reflection layer of the tandem type solar cell as described above.

The surface of the lower electrode 111a may be textured as described above in order to improve the photoelectric conversion efficiency of the solar cell, like the surface of the substrate 100.

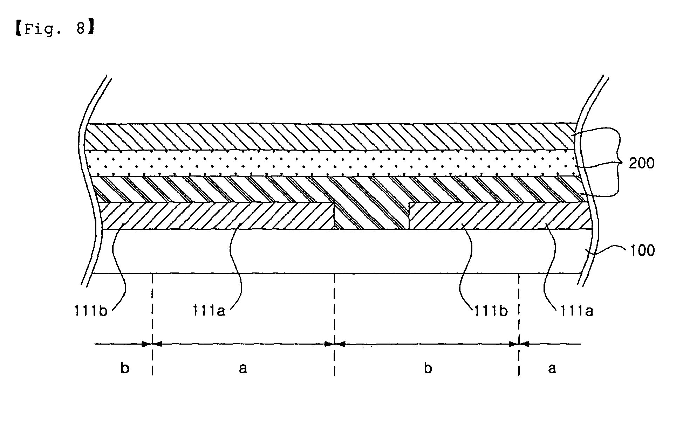

Next, referring to Fig. 8, p and n type semiconductor layers or p, i, and n type semiconductor layers may be stacked on the entire upper surface of the substrate 100. For example, in the first embodiment of the present invention, p, i, and n type semiconductor layers 200 are sequentially formed. The semiconductor layers 200 may be made of silicon which is generally used. These silicon layers 200 may be formed by using CVD such as PECVD or LPCVD, and serve as a photoelectric element that can produce photoelectro-motive force (power) upon receiving light in the follow-up process.

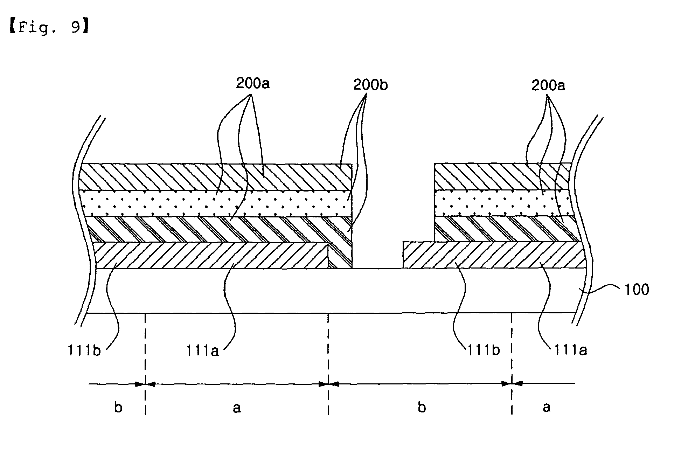

Next, referring to Fig. 9, the silicon layers 200 may be patterned to have certain patterns, and in this case, a laser scribing, which is an etching method using a laser light source, may be used. Hereinafter, in order to equivalently describe with an operation circuit of the solar cell, the silicon layers 200 patterned at the unit cell area (a) will be described as a photoelectric element unit 200a, and the silicon layers 200 patterned at the wiring area (b) will be described as a dummy photoelectric element 200b. Namely, the photoelectric element unit 200a produces photoelectro-motive force (power) as electrons and holes generated upon receiving light move to the lower electrode 111a and an upper electrode 400 to be formed later, but the dummy photoelectric element 200b cannot substantially produce photoelectro-motive force. Thus, the photoelectric element unit 200a can be formed on the lower electrode 111a, and at the same time, the dummy photoelectric element 200b may be formed on the wiring area (b) of the substrate 100 and connected as the same layer to one side of the photoelectric element unit 200a facing the lower connection electrode 111b.

In the first embodiment of the present invention as discussed above, the configuration of the photoelectric element unit 200a may be understood to be the same as that of the photoelectric element unit 200a of the tandem type solar cell as described above with reference to Figs. 2 to 5. Namely, the photoelectric element unit 200a in the first embodiment of the present invention has the structure in which the p, i, and n type semiconductor layers 200 are stacked, but the present invention is not limited thereto, and the photoelectric element 200a may have a structure in which the p, i, and n type polycrystalline semiconductor layers and the p, i, and n type amorphous semiconductor layers are stacked as shown in Fig. 5. Such various structures of the photoelectric element unit may be also applied to the following embodiments in the same manner.

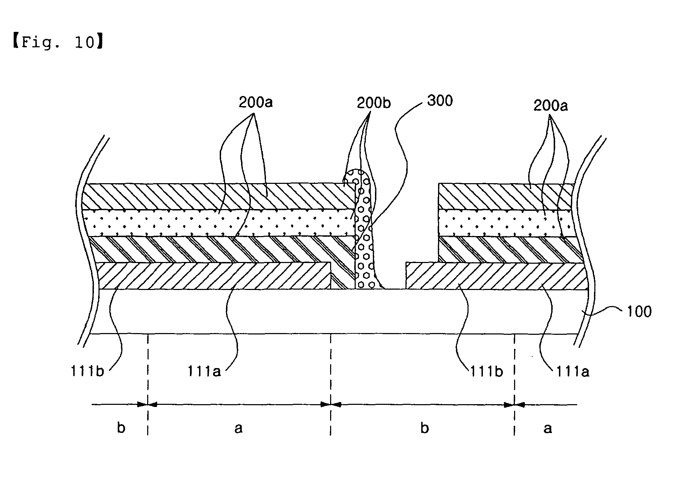

Next, referring to Fig. 10, a side wall insulating layer 300 may be formed on the side of the dummy photoelectric element 200b. The side wall insulating layer 300 may be any one of a silicon nitride (SiNₓ) layer and a silicon oxide (SiOₓ) layer, or a layer formed by stacking them. The side wall insulating layer 300 may be formed by using an inkjet printing method in which ink is jetted through a head configured as a nozzle. The side of the dummy photoelectric element 200b connected to the photoelectric element unit 200a can be electrically insulated by the side insulating layer 300.

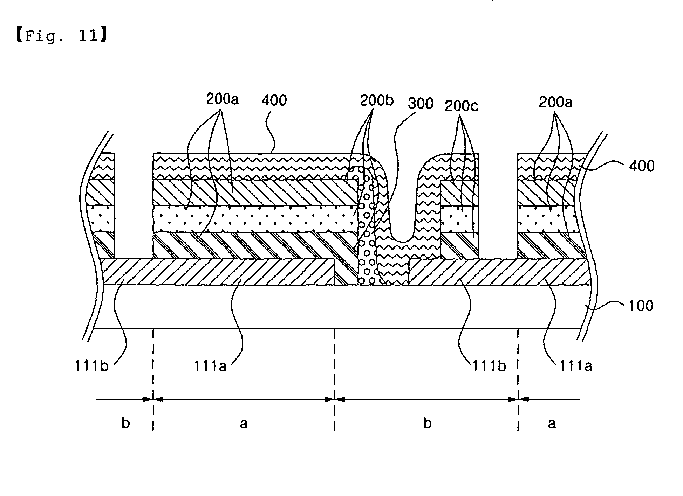

Finally, referring to Fig. 11, an upper conductive layer (not shown) made of a conductive material is formed on the entire upper surface of the substrate 100. The upper conductive layer may be formed by using the same material and method as those of the upper electrode 400 of the tandem type solar cell as described above.

And then, the upper conductive layer may be patterned to form the upper electrode 400 of certain patterns, and in this case, a laser scribing method, which is an etching method using a laser light source, may be used. At this point, the upper electrode 400 of the unit cell area (a) serves as an electrode of the photoelectric element unit 200a, and the upper electrode 400 of the wiring area (b) serves as a wiring connecting the photoelectric element unit with a neighboring different photoelectric element unit (namely, a wiring connecting the unit cells of the solar cell).

Meanwhile, when the upper conductive layer is patterned, the silicon layers 200 formed on the lower connection electrode 111b may be simultaneously patterned to form a side wall dummy photoelectric element 200c. Namely, the side wall dummy photoelectric element 200c may be formed to be spaced apart from the photoelectric element unit 200a and the dummy photoelectric element 200b on the lower connection electrode 111b.

In the first embodiment of the present invention, the side wall insulating layer 300 is formed on the wiring area (b) of the substrate 100, and in this case, the side wall insulating layer 300 may be positioned between the side of the dummy photoelectric element 200b connected as the same layer with the photoelectric element unit 200a and the upper electrode 400, to thus effectively prevent the photoelectric element unit 200a and the upper electrode 400 from being short-circuited to generate a leakage current.

In addition, in the first embodiment of the present invention, the dummy photoelectric element 200b is formed on the wiring area (b) of the substrate 100 but is not in contact with the lower connection electrode 111b, thereby preventing a short circuit phenomenon of the lower electrode 111a and the lower connection electrode 111b between the unit cells of the solar cell.

Also, in the first embodiment of the present invention, when the unit cells of the solar cell are connected in series, the upper electrode 400 is connected by including the side of the lower connection electrode 111b, thereby increasing a connection area to thus improve the reliability of the solar cell.

### [Second embodiment]

The configuration of a series connection type solar cell in accordance with a second embodiment of the present invention is the same as the series connection type solar cell in accordance with the first embodiment of the present invention above described above, except for the wiring area (b). Thus, in the following second embodiment, a repeated description as that of the first embodiment will be omitted.

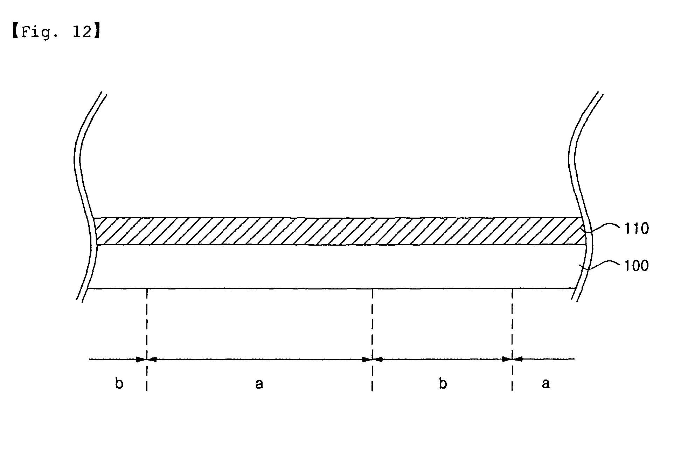

Figs. 12 to 17 are views illustrating a series connection type solar cell and a manufacturing method thereof in accordance with a second embodiment of the present invention.

First, referring to Fig. 12, a substrate 100 including a plurality of wiring areas (b) positioned between a plurality of unit cell areas (a) is provided.

Next, a lower conductive layer 110 made of a conductive material is formed on the substrate 100.

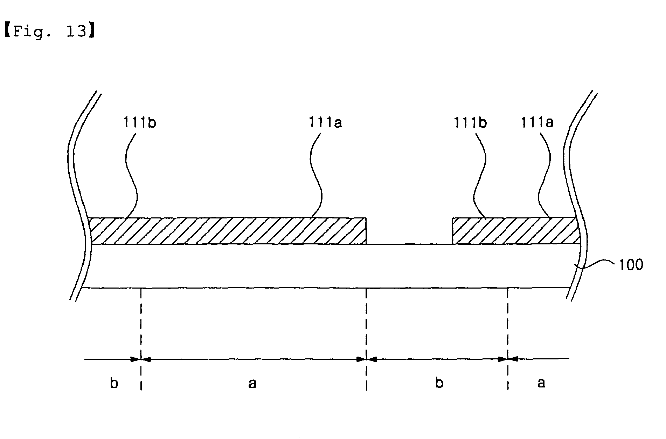

Thereafter, referring to Fig. 13, the lower conductive layer 110 is patterned to form a lower electrode layer 111 (111a and 111b) of certain patterns. Namely, the lower electrode 111a is formed on the unit cell area (a) of the substrate 100, and at the same time, the lower connection electrode 111b of certain patterns connected as the same layer to one side of the lower electrode 111a is formed on the wiring area (b) of the substrate 100.

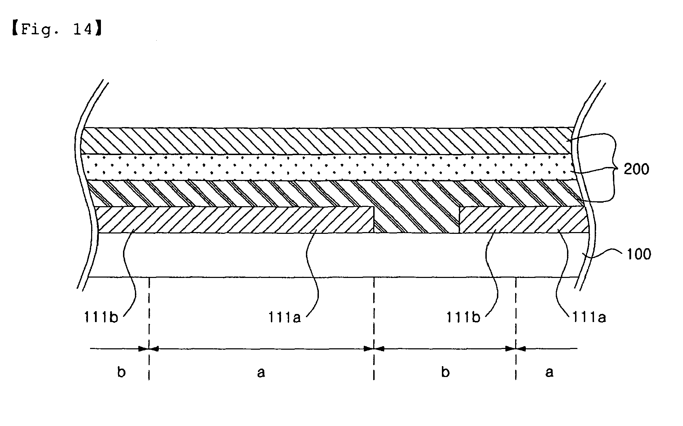

Next, referring to Fig. 14, p, i, and n type semiconductor layers 200 are sequentially formed on the entire upper surface of the substrate 100. The semiconductor layers 200 may be made of generally used silicon.

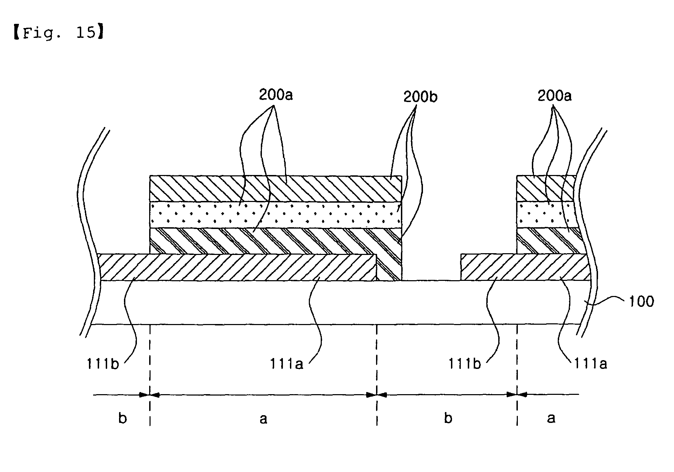

Subsequently, referring to Fig. 15, the silicon layers 200 may be patterned to have certain patterns. Accordingly, a photoelectric element unit 200a may be formed on the lower electrode 111a, and at the same time, a dummy photoelectric element 200b may be formed on the wiring area (b) of the substrate 100 and connected as the same layer to one side of the photoelectric element unit 200a facing the lower connection electrode 111b.

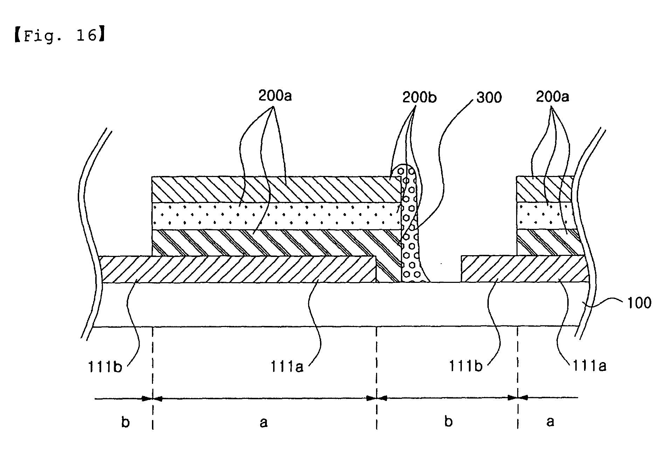

Next, with reference to Fig. 16, a side wall insulating layer 300 may be formed on the side of the dummy photoelectric element 200b. The side insulating layer 300 may electrically insulate the side of the dummy photoelectric element 200b connected to the photoelectric element unit 200a.

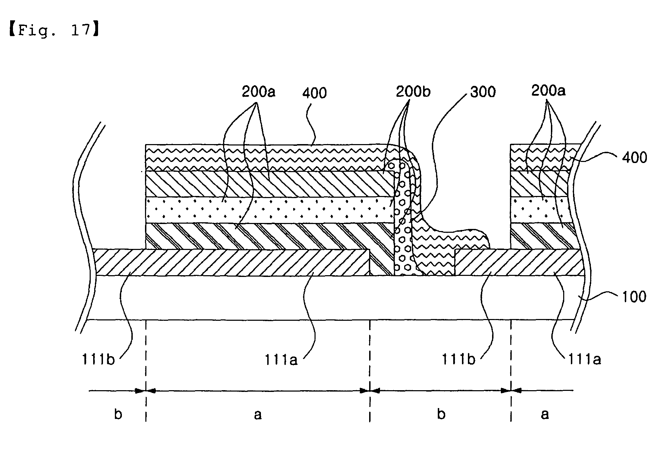

Finally, referring to Fig. 17, an upper electrode layer (not shown) made of a conductive material, is formed on the entire upper surface of the substrate 100.

And then, the upper conductive layer may be patterned to form an upper electrode 400 of certain patterns. In this case, the upper electrode 400 of the unit cell area (a) serves as an electrode of the photoelectric element unit 200a, and the upper electrode 400 of the wiring area (b) serves as a wiring connecting the photoelectric element unit with a neighboring different photoelectric element unit (namely, a wiring connecting the unit cells of the solar cell).

In the second embodiment of the present invention, because the side wall dummy photoelectric element is not included, the structure and manufacturing method of the solar cell are simplified, and because the area of the unit cell area (a), which is a light receiving area, can be increased, the amount of power that can be produced per area of the same substrate can be increased. Of course, the second embodiment of the present invention can obtain all the advantageous of the first embodiment as described above.

### [Third embodiment]

The configuration of a series connection type solar cell in accordance with a third embodiment of the present invention is the same as the series connection type solar cell in accordance with the first embodiment as described above, except for the wiring area (b). Thus, in the following third embodiment, a repeated description as that of the first embodiment will be omitted.

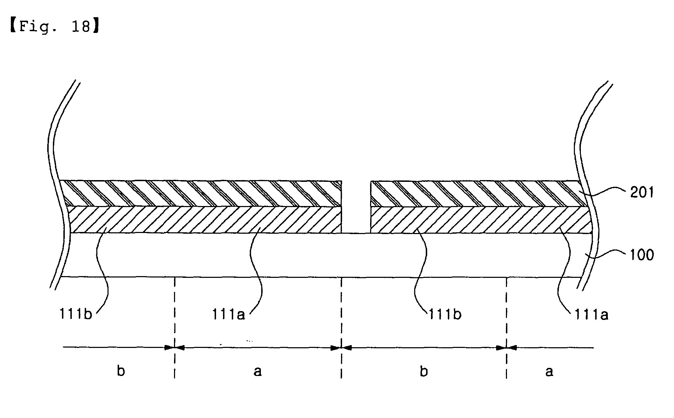

Figs. 18 to 22 are views illustrating a series connection type solar cell and a manufacturing method thereof in accordance with a third embodiment of the present invention.

First, referring to Fig. 18, a substrate 100 including a plurality of wiring areas (b) positioned between a plurality of unit cell areas (a) is provided.

Next, a lower conductive layer (not shown) made of a conductive material is formed on the substrate 100.

Thereafter, p, i, and n type semiconductor layers 200 may be sequentially formed on the lower conductive layer. In this case, any one of silicon layers 200 (201, 202, and 203), excluding a silicon layer having the largest resistance, may be first formed. The semiconductor layers 200 may be made of generally used silicon.

Subsequently, the lower conductive layer and the previously formed silicon layer are simultaneously patterned to form a lower electrode layer 111 (111a and 111b) of certain patterns and a first silicon layer 201. At this point, the lower electrode 111a is formed on the unit cell area (a) of the substrate 100, and at the same time, the lower connection electrode 111b of certain patterns connected as the same layer to one side of the lower electrode 111a is formed on the wiring area (b) of the substrate 100.

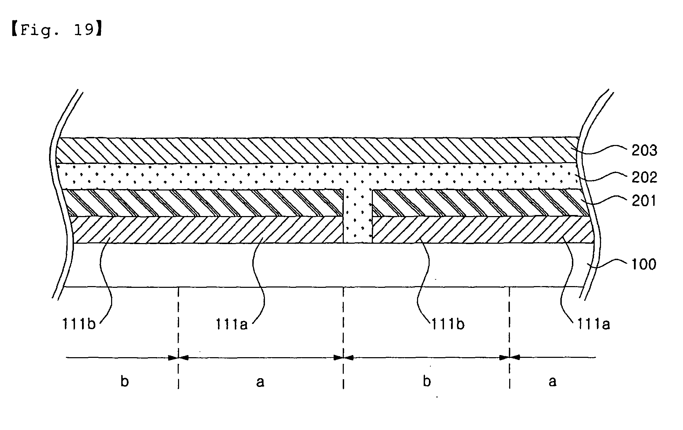

Next, referring to Fig. 19, second and third silicon layers 202 and 203 are sequentially formed on the entire upper surface of the substrate 100. Accordingly, the silicon layers 200 can be completed together with the first silicon layer 201 formed in Fig. 18.

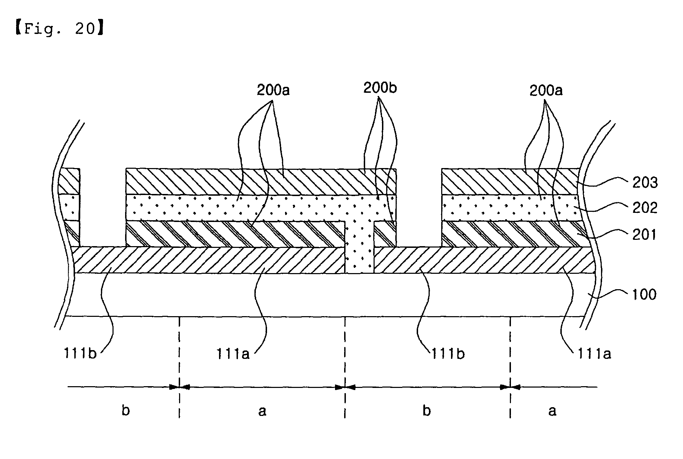

And then, referring to Fig. 20, the silicon layer 200 (201, 202, and 203) may be patterned to have certain patterns. Accordingly, a photoelectric element unit 200a may be formed on the lower electrode 111a, and at the same time, a dummy photoelectric element 200b may be formed on the lower connection electrode 111b and connected to one side of the photoelectric element unit 200a facing the lower connection electrode 111b.

Meanwhile, in the present embodiment, preferably, the resistance of the second silicon layer 202 formed on the wiring area (b) of the substrate 100, among the silicon layers 200 included in the dummy photoelectric element 200b is greater than those of the first and third silicon layers 201 and 203. This is to effectively prevent a leakage current that may be potentially generated between the lower electrode 111a and the lower connection electrode 111b by disposing the second silicon layer 202 having the greatest resistance therebetween.

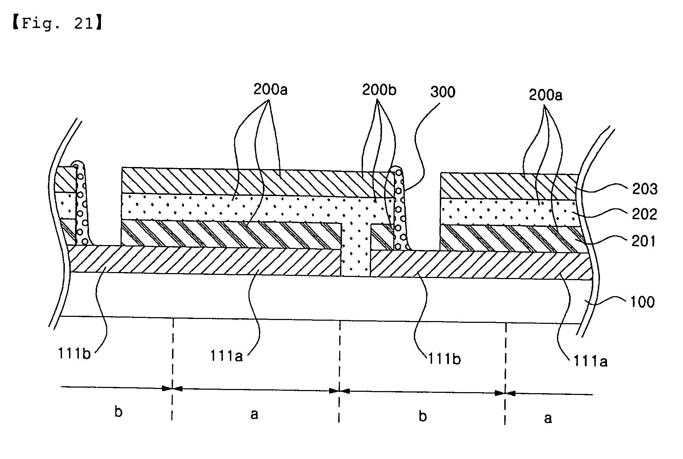

Next, referring to Fig. 21, a side wall insulating layer 300 may be formed on the side of the dummy photoelectric element 200b. The side insulating layer 300 may electrically insulate the side of the dummy photoelectric element 200b connected to the photoelectric element unit 200a.

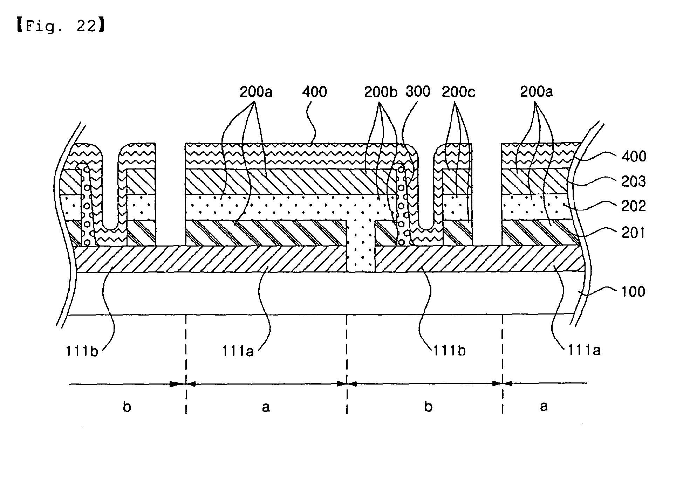

Finally, referring to Fig. 22, an upper electrode layer (not shown) made of a conductive material is formed on the entire upper surface of the substrate 100.

And then, the upper conductive layer may be patterned to form an upper electrode 400 of certain patterns. In this case, the upper electrode 400 of the unit cell area (a) serves as an electrode of the photoelectric element unit 200a, and the upper electrode 400 of the wiring area (b) serves as a wiring connecting the photoelectric element unit with a neighboring different photoelectric element unit (namely, a wiring connecting the unit cells of the solar cell).

Meanwhile, when the upper conductive layer is patterned, the silicon layer 200 formed on the lower connection electrode 111b may be simultaneously patterned to form a side wall dummy photoelectric element 200c. Namely, the side wall dummy photoelectric element 200c may be formed to be spaced apart from the photoelectric element unit 200a and the dummy photoelectric element 200b on the lower connection electrode 111b.

In the third embodiment of the present invention, because the silicon layer 202 having the greatest resistance, among the silicon layers 200 constituting the dummy photoelectric element 200b, is formed on the wiring area (b) of the substrate 100 (namely, between the lower electrode 111a and the lower connection electrode 111b), a short-circuit phenomenon of the lower electrode 111a and the lower connection electrode 111b between the unit cells of the solar cell can be prevented.

In addition, in the third embodiment of the present invention, because the dummy photoelectric element 200b and the side wall insulating layer 300 are positioned on the lower connection electrode 111b, step coverage characteristics of the upper electrode 400 can be improved to enhance the reliability of the solar cell.

Of course, besides, the third embodiment of the present invention can obtain all the advantageous of the first embodiment as discussed above.

### [Fourth embodiment]

The configuration of a series connection type solar cell in accordance with a fourth embodiment of the present invention is the same as the series connection type solar cell in accordance with the first embodiment as described above, except for the wiring area (b). Thus, in the following fourth embodiment, a repeated description as that of the first embodiment will be omitted.

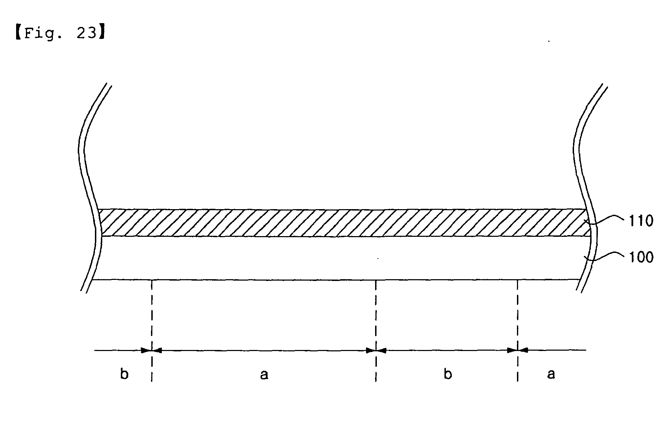

Figs. 23 to 27 are views illustrating a series connection type solar cell and a manufacturing method thereof in accordance with a fourth embodiment of the present invention.

First, with reference to Fig. 23, a substrate 100 including a plurality of wiring areas (b) positioned between a plurality of unit cell areas (a) is provided.

Next, a lower conductive layer 110 made of a conductive material is formed on the substrate 100.

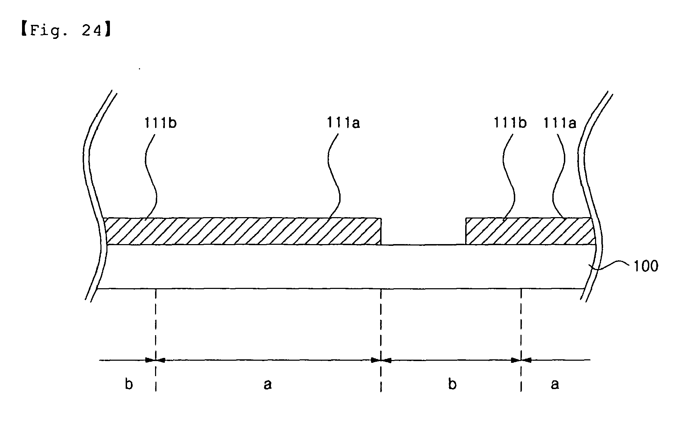

And then, referring to Fig. 24, the lower conductive layer 110 is patterned to form lower electrode layers 111 (111a and 111b) of certain patterns. Namely, the lower electrode 111a is formed on the unit cell area (a) of the substrate 100, and at the same time, the lower connection electrode 111b of certain patterns is formed on the wiring area (b) of the substrate 100 such that it is connected as the same layer to one side of the lower electrode 111a.

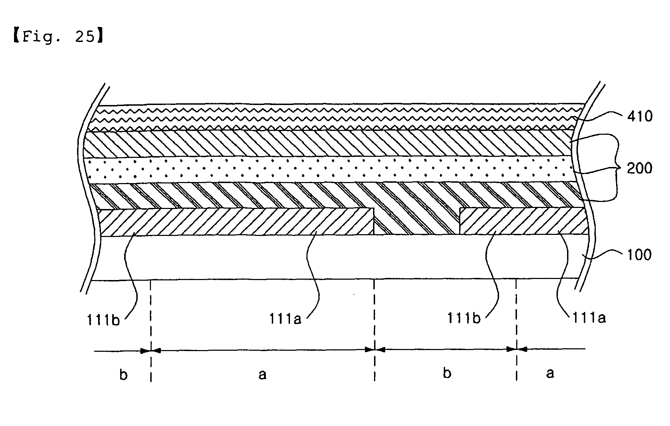

Next, referring to Fig. 25, p type, i type, and n type semiconductor layers 200 are sequentially formed on the entire upper surface of the substrate 100, and in this case, the semiconductor layers 200 may be made of generally used silicon.

Subsequently, an upper conductive layer 410 made of a conductive layer may be formed on the entire upper portion of the substrate 100.

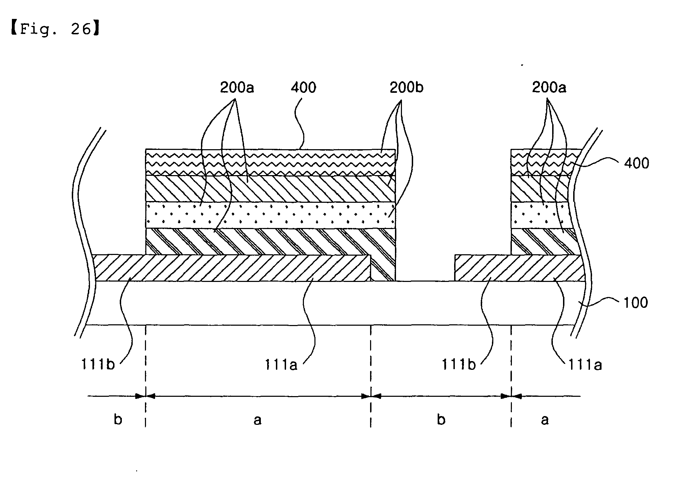

Thereafter, referring to Fig. 26, the upper conductive layer 410 and the silicon layers 200 may be patterned to simultaneously form an upper electrode 400 and silicon layers 200a and 200b of certain patterns. Accordingly, the photoelectric element unit 200a can be formed on the lower electrode 111a, and at the same time, a dummy photoelectric element 200b may be formed on the wiring area (b) of the substrate 100 and connected as the same layer to one side of the photoelectric element unit 200a facing the lower connection electrode 111b.

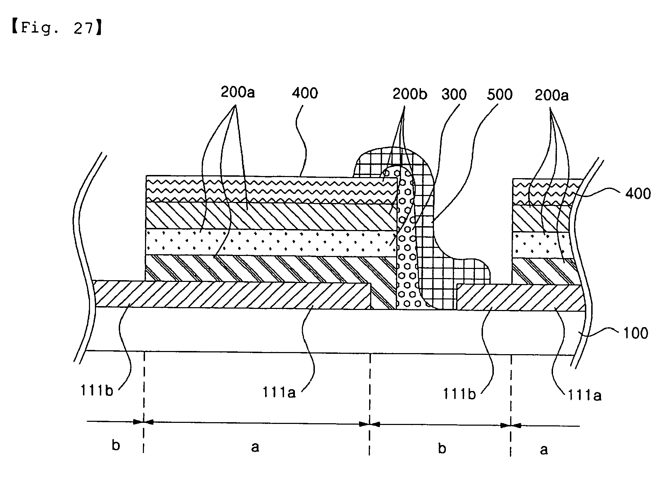

Finally, referring to Fig. 27, a side wall insulating layer 300 may be formed on the side of the dummy photoelectric element 200b. The side insulating layer 300 may electrically insulate the side of the dummy photoelectric element 200b connected to the photoelectric element unit 200a. And then, an electrode connection layer 500 may be formed on the side wall insulating layer 300. The electrode connection layer 500 electrically connects the upper electrode 400 and the lower connection electrode 111b. Thus, the upper electrode 400 serves as an electrode of the photoelectric element unit 200a, and the electrode connection layer 500 serves as a wiring connecting the photoelectric element unit with a neighboring different photoelectric element unit (namely, a wiring connecting the unit cells of the solar cell).

Meanwhile, preferably, the side wall insulating layer 300 and the electrode connection layer 500 are simultaneously formed in a single process, and in this case, an inkjet printing method using dual-nozzle jetting ink of different materials.

The side wall insulating layer 300 may use ink of a known insulating material without any limitations. For example, it may be one of silicon nitride (SiNₓ) and silicon oxide (SiOₓ). The electrode connection layer 500 may be formed by using ink made of a known conductive material without any limitations. For example, it may be any one of silver (Ag) and carbon nanotube (CNT).

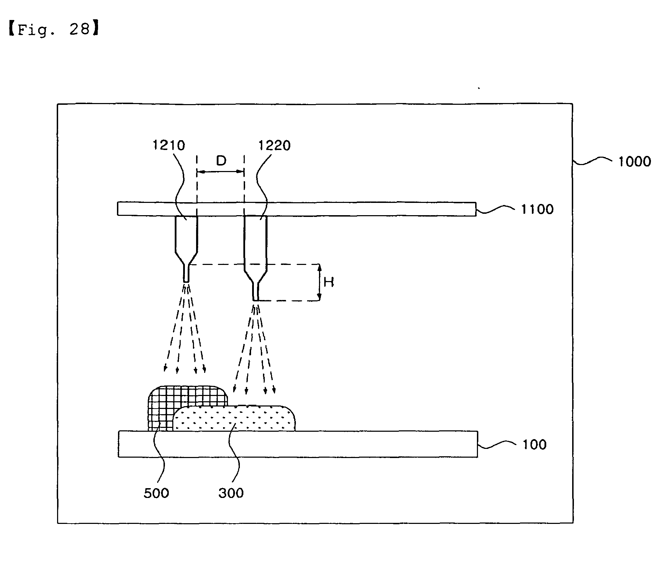

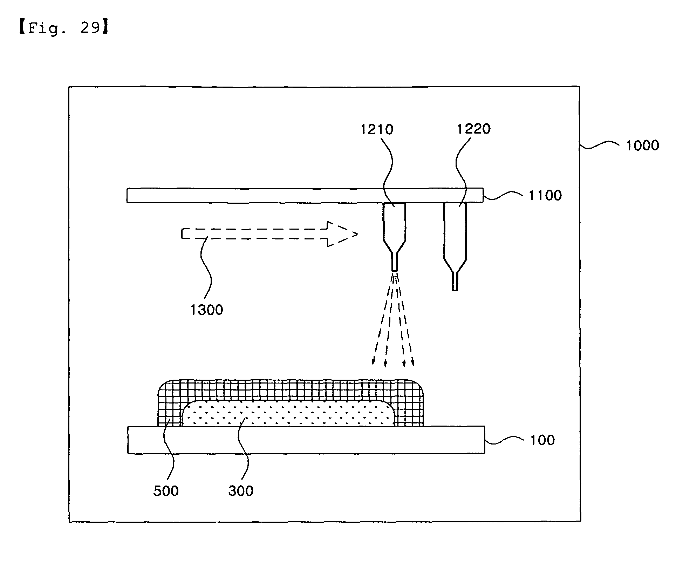

Thus, through the single process, the side of the dummy photoelectric element 200b connected to the photoelectric element unit 200a can be electrically insulated, and at the same time, the photoelectric element unit 200a can be connected in series to a neighboring different photoelectric element unit. The inkjet printing method using dual nozzles will be clearly understood by the following description with reference to Figs. 28 and 29.

Figs. 28 and 29 are views illustrating a method for manufacturing a side wall insulating layer and an electrode connection layer of a solar cell in accordance with an embodiment of the present invention.

With reference to Figs. 28 and 29, dual nozzles 1210 and 1220 positioned within a processing chamber 1000 are provided in a scanning unit 1100 such that they have different heights (H) and are positioned to be spaced apart by a certain distance (D).

The dual nozzles 1210 and 1220 jet ink of different materials on the substrate 100 along a scan direction 1300 at a uniform speed. The position and shape of patterns formed on the substrate 100 may vary depending on the distance (D) and the height difference (H) between the first and second nozzles 1210 and 1220. Namely, the side wall insulating layer 300 is formed on the substrate 100 and the electrode connection layer 500 is formed to cover the side wall insulating layer 300, so these two patterns can be simultaneously formed. Thus, because the two different patterns are simultaneously formed through the single process, the processing step and processing time can be reduced, and because the process is performed in the single processing chamber 1000, an introduction of a foreign material such as a particle, or the like, between the side wall insulating layer 300 and the electrode connection layer 500 can be prevented.

Meanwhile, after the side wall insulating layer 300 and the electrode connection layer 500 are formed by using the inkjet printing method, the side wall insulating layer 300 and the electrode connection layer 500 are thermally cured or UV-cured to remove a solvent, or the like, present within the layers. At this time, a UV-curing method may be more preferably used, and to this end, a UV irradiator (not shown) may be installed in the scanning unit 1100. Then, the printing and UV curing operation can be simultaneously performed on the side wall insulating layer 300 and the electrode connection layer 500 within the single processing chamber 1000.

Meanwhile, in the above description, the side wall insulating layer 300 and the electrode connection layer 500 are simultaneously formed, but the present invention is not limited thereto. Namely, the side wall insulating layer 300 and the electrode connection layer 500 may be sequentially formed, and in this case, the side wall insulating layer 300 may be first formed and the electrode connection layer 500 may be formed after the lapse of a certain time.

While the present invention has been described with respect to certain preferred embodiments, it will be apparent to those skilled in the art that various changes and modifications may be made without departing from the scope of the invention as defined in the following claims.

## Claims

1. A solar cell comprising:
a substrate;
a lower electrode formed on the substrate;
a photoelectric element unit including a polycrystalline photoelectric element formed on the lower electrode and formed by stacking a plurality of polycrystalline semiconductor layers and a amorphous photoelectric element formed on the polycrystalline photoelectric element and formed by stacking a plurality of amorphous semiconductor layers; and
an upper electrode formed on the photoelectric element unit.

2. A solar cell comprising:
a substrate including a plurality of unit cell areas and a plurality of wiring areas positioned between the unit cell areas;
a lower electrode formed on the unit cell area of the substrate;
a lower connection electrode formed on the wiring area of the substrate and connected as the same layer to one side of the lower electrode;
a photoelectric element unit formed on the lower electrode and including at least one of an amorphous photoelectric element and a polycrystalline photoelectric element;
a dummy photoelectric element formed on the wiring area of the substrate and connected as the same layer to one side of the photoelectric element unit facing the lower connection electrode;
a side wall dummy photoelectric element formed on the lower connection electrode and spaced apart from the dummy photoelectric element and the photoelectric element unit;
an upper electrode formed on the photoelectric element unit and the dummy photoelectric element and connected by including the side of the lower connection electrode connected to a lower electrode of a neighboring unit cell area; and
a side wall insulating layer positioned on the wiring area of the substrate and formed between the side of the dummy photoelectric element and the upper electrode.

3. A solar cell comprising:
a substrate including a plurality of unit cell areas and a plurality of wiring areas positioned between the unit cell areas;
a lower electrode formed on the unit cell area of the substrate;
a lower connection electrode formed on the wiring area of the substrate and connected as the same layer to one side of the lower electrode;
a photoelectric element unit formed on the lower electrode and including at least one of an amorphous photoelectric element and a polycrystalline photoelectric element;
a dummy photoelectric element formed on the wiring area of the substrate and connected as the same layer to one side of the photoelectric element unit facing the lower connection electrode;
an upper electrode formed on the photoelectric element unit and the dummy photoelectric element and connected by including the side of the lower connection electrode connected to a lower electrode of a neighboring unit cell area; and
a side wall insulating layer positioned on the wiring area of the substrate and formed between the side of the dummy photoelectric element and the upper electrode.

4. A solar cell comprising:
a substrate including a plurality of unit cell areas and a plurality of wiring areas positioned between the unit cell areas;
a lower electrode formed on the unit cell area of the substrate;
a lower connection electrode formed on the wiring area of the substrate and connected as the same layer to one side of the lower electrode;
a photoelectric element unit formed on the lower electrode and including at least one of an amorphous photoelectric element and a polycrystalline photoelectric element;
a dummy photoelectric element formed on the lower connection electrode and connected to one side of the photoelectric element unit facing the lower connection electrode;
a side wall dummy photoelectric element formed on the lower connection electrode and spaced apart from the dummy photoelectric element and the photoelectric element unit;
an upper electrode formed on the photoelectric element unit and the dummy photoelectric element and connected to an upper side of the lower connection electrode connected to a lower electrode of a neighboring unit cell area; and
a side wall insulating layer positioned on the lower connection electrode and formed between the side of the dummy photoelectric element and the upper electrode.

5. A solar cell comprising:
a substrate including a plurality of unit cell areas and a plurality of wiring areas positioned between the unit cell areas;
a lower electrode formed on the unit cell area of the substrate;
a lower connection electrode formed on the wiring area of the substrate and connected as the same layer to one side of the lower electrode;
a photoelectric element unit formed on the lower electrode and including at least one of an amorphous photoelectric element and a polycrystalline photoelectric element;
a dummy photoelectric element formed on the wiring area of the substrate and connected as the same layer to one side of the photoelectric element unit facing the lower connection electrode, and;
an upper electrode formed on the photoelectric element unit and the dummy photoelectric element;
a side wall insulating layer positioned on the wiring area of the substrate and formed on the side of the dummy photoelectric element; and
an electrode connection layer formed on the side wall insulating layer and connecting the upper electrode to the lower connection electrode connected to a lower electrode of a neighboring unit cell area.

6. The solar cell of any one of claims 2 to 5, wherein the photoelectric element unit comprises:
a first polycrystalline semiconductor layer formed on the lower electrode;
a second polycrystalline semiconductor layer formed on the first polycrystalline semiconductor layer; and
a third polycrystalline semiconductor layer formed on the second polycrystalline semiconductor layer.

7. The solar cell of any one of claims 2 to 5, wherein the photoelectric element unit comprises:
a first polycrystalline semiconductor layer formed on the lower electrode;
a second polycrystalline semiconductor layer formed on the first polycrystalline semiconductor layer;
a third polycrystalline semiconductor layer formed on the second polycrystalline semiconductor layer;
a first amorphous semiconductor layer formed on the third polycrystalline semiconductor layer;
a second amorphous semiconductor layer formed on the first amorphous semiconductor layer; and
a third amorphous semiconductor layer formed on the second amorphous semiconductor layer.

8. The solar cell of claim 7, wherein the polycrystalline semiconductor layer is a polycrystalline silicon layer, and the amorphous semiconductor layer is an amorphous silicon layer.

9. The solar cell of claim 7, wherein the polycrystalline semiconductor layer is crystallized through any one of solid phase crystallization (SPC), excimer laser annealing (ELA), sequential lateral solidification (SLS), metal induced crystallization (MIC), and metal induced lateral crystallization (MILC).

10. The solar cell of any one of claims 2 to 5, wherein the side wall insulating layer is any one of silicon nitride (SiNₓ) layer and silicon oxide (SiOₓ) layer, or a layer formed by stacking the silicon nitride layer and silicon oxide layer.

11. The solar cell of claim 4, wherein, among the semiconductor layers included in the dummy photoelectric element, the semiconductor layer formed on the wiring area of the substrate has the largest resistance.

12. The solar cell of claim 5, wherein the electrode connection layer is a conductor.

13. The solar cell of claim 5, wherein the side wall insulating layer and the electrode connection layer are formed through an inkjet printing method using dual nozzles.

14. The solar cell of any one of claims 2 to 5, further comprising:
a reflection layer made of a transparent conductive material between the lower electrode and the photoelectric element unit.

15. The solar cell of any one of claims 2 to 5, further comprising:
a connection layer made of a transparent conductive material between the polycrystalline photoelectric element and the amorphous photoelectric element.

16. A method for fabricating a solar cell, comprising:
forming a lower electrode on a substrate;
forming a photoelectric element unit on the lower electrode, wherein the photoelectric element unit includes a polycrystalline photoelectric element formed by stacking a plurality of polycrystalline semiconductor layers formed on the lower electrode and an amorphous photoelectric element formed by stacking a plurality of amorphous semiconductor layers formed on the polycrystalline photoelectric element; and
forming an upper electrode on the photoelectric element unit.

17. A method for fabricating a solar cell, comprising:
providing a substrate including a plurality of unit cell areas and a plurality of wiring areas positioned between the unit cell areas;
forming a lower electrode on the unit cell area of the substrate, and a lower connection electrode connected as the same layer to one side of the lower electrode and positioned on the wiring area;
forming semiconductor layers constituting at least one of an amorphous photoelectric element and a polycrystalline photoelectric element on the lower electrode and the lower connection electrode, and at the same time, forming a dummy photoelectric element on the wiring area of the substrate;
forming a side wall insulating layer on the side of the dummy photoelectric element;
forming an upper conductive layer on the substrate; and
simultaneously patterning the semiconductor layers and the upper conductive layer, the semiconductor layers being formed with a photoelectric element unit positioned on the lower electrode and a side wall dummy photoelectric element positioned on the lower connection electrode to be spaced apart from the photoelectric element unit, the upper conductive layer being formed with an upper electrode connecting the photoelectric element unit to a neighboring photoelectric element unit in series.

18. A method for fabricating a solar cell, comprising:
providing a substrate including a plurality of unit cell areas and a plurality of wiring areas positioned between the unit cell areas;
forming a lower electrode on the unit cell area of the substrate, and a lower connection electrode connected as the same layer to one side of the lower electrode and positioned on the wiring area;
forming a photoelectric element unit including at least one of an amorphous photoelectric element and a polycrystalline photoelectric element on the lower electrode, and at the same time, forming a dummy photoelectric element on the wiring area of the substrate;
forming a side wall insulating layer on the side of the dummy photoelectric element;
forming an upper conductive layer formed on the substrate; and
patterning the upper conductive layer to form an upper electrode connecting the photoelectric element unit to a neighboring photoelectric element unit in series.

19. A method for fabricating a solar cell, comprising:
providing a substrate including a plurality of unit cell areas and a plurality of wiring areas positioned between the unit cell areas;
forming a lower electrode on the unit cell area of the substrate, and a lower connection electrode connected as the same layer to one side of the lower electrode and positioned on the wiring area;
forming semiconductor layers constituting at least one of an amorphous photoelectric element and a polycrystalline photoelectric element on the substrate;
patterning the semiconductor layer to form a dummy photoelectric element on the wiring area and the lower connection electrode;
forming a side wall insulating layer on the side of the dummy photoelectric element;
forming an upper conductive layer on the substrate; and
simultaneously patterning the semiconductor layers and the upper conductive layer, the semiconductor layers being formed with a photoelectric element unit positioned on the lower electrode and a side wall dummy photoelectric element positioned on the lower connection electrode to be spaced apart from the photoelectric element unit, the upper conductive layer being formed with an upper electrode connecting the photoelectric element unit to a neighboring photoelectric element unit in series.

20. A method for fabricating a solar cell, comprising:
providing a substrate including a plurality of unit cell areas and a plurality of wiring areas positioned between the unit cell areas;
forming a lower electrode on the unit cell area of the substrate, and a lower connection electrode connected as the same layer to one side of the lower electrode and positioned on the wiring area;
forming a photoelectric element unit including at least one of an amorphous photoelectric element and a polycrystalline photoelectric element on the lower electrode, and at the same time, forming a dummy photoelectric element on the wiring area of the substrate and an upper electrode on the photoelectric element unit and the dummy photoelectric element; and
forming a side wall insulating layer on the side of the dummy photoelectric element, and at the same time, forming an electrode connection layer formed on the side wall insulating layer and connecting the photoelectric element unit to a neighboring photoelectric element unit in series.

21. The method of any one of claims 17 to 20, wherein the photoelectric element unit comprises:
a first polycrystalline semiconductor layer formed on the lower electrode;
a second polycrystalline semiconductor layer formed on the first polycrystalline semiconductor layer; and
a third polycrystalline semiconductor layer formed on the second polycrystalline semiconductor layer.

22. The method of any one of claims 17 to 20, wherein the photoelectric element unit comprises:
a first polycrystalline semiconductor layer formed on the lower electrode;
a second polycrystalline semiconductor layer formed on the first polycrystalline semiconductor layer;
a third polycrystalline semiconductor layer formed on the second polycrystalline semiconductor layer;
a first amorphous semiconductor layer formed on the third polycrystalline semiconductor layer;
a second amorphous semiconductor layer formed on the first amorphous semiconductor layer; and
a third amorphous semiconductor layer formed on the second amorphous semiconductor layer.

23. The method of claim 22, wherein the polycrystalline semiconductor layer is a polycrystalline silicon layer, and the amorphous semiconductor layer is an amorphous silicon layer.

24. The method of claim 22, wherein the polycrystalline semiconductor layer is crystallized through any one of solid phase crystallization (SPC), excimer laser annealing (ELA), sequential lateral solidification (SLS), metal induced crystallization (MIC), and metal induced lateral crystallization (MILC).

25. The method of any one of claims 17 to 20, wherein the side wall insulating layer is any one of silicon nitride (SiNₓ) layer and silicon oxide (SiOₓ) layer, or a layer formed by stacking the silicon nitride layer and silicon oxide layer.

26. The method of claim 19, wherein, among the semiconductor layers included in the dummy photoelectric element, the semiconductor layer formed on the wiring area of the substrate has the largest resistance.

27. The method of claim 20, wherein the electrode connection layer is a conductor.

28. The method of claim 20, wherein the side wall insulating layer and the electrode connection layer are formed through an inkjet printing method using dual nozzles.

29. The method of any one of claims 17 to 20, further comprising:
forming a reflection layer made of a transparent conductive material between the lower electrode and the photoelectric element unit.

30. The method of any one of claims 17 to 20, further comprising:
forming a connection layer made of a transparent conductive material between the polycrystalline photoelectric element and the amorphous photoelectric element.
